# EUROPEAN PATENT APPLICATION

(11) **EP 4 607 277 A1**
(43) Date of publication of application: **27.08.2025**
(21) Application number: 22962854.0
(22) Date of filing: 24.10.2022
(51) Int. Cl.: G03F 7/004, G03F 7/039, G03F 7/20, C08F 212/14, C08F 220/18, C08K 5/092

(54) **CHEMICALLY AMPLIFIED POSITIVE PHOTORESIST COMPOSITION FOR IMPROVING PATTERN PROFILE AND ENHANCING ADHESION**

(30) Priority: 17.10.2022 KR 20220133202
(71) Applicant: Ycchem Co., Ltd., Gyeongsangbuk-do 40046 (KR)
(72) Inventor: CHOI, Young Cheol, Gumi-si Gyeongsangbuk-do 39179 (KR); LEE, Su Jin, Daegu 42634 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2022/016245
(87) International publication number: WO 2024/085292

(57) **Abstract**

The present invention relates to a chemically amplified positive photoresist composition for improving a pattern profile and enhancing adhesion, the photoresist composition being exposable by a light source with a wavelength of 248 nm, and comprising, on the basis of the total amount of the composition, 1-5 wt% of a polyhydric alcohol additive represented by chemical formulas 1-8 in order to implement a vertical profile without pattern collapse.

## Description

### Technical Field

The present disclosure relates to a chemically amplified positive photoresist composition for use in improving a pattern profile and enhancing adhesion between a pattern and a substrate.

### Background Art

In recent years, with developments in semiconductor manufacturing process technologies, semiconductor devices have been required to become smaller and more highly integrated. Accordingly, technologies capable of realizing ultra-fine patterns with line widths of tens of nanometers or less have been demanded. Advances in such technologies to form ultra-fine patterns have been fulfilled by light sources having smaller wavelengths, developments in process technologies by the light sources, developments of photoresists suitable for the light sources, and the like.

Photoresists are used in photolithography for forming all kinds of patterns. A photoresist refers to photosensitive resins capable of enabling images corresponding to exposure patterns to be obtainable by solubility changes in a developer under the action of light.

Such methods of forming photoresist patterns include a method using a negative tone developer (negative tone development (NTD)) and a method using a positive tone developer (positive tone development (PTD)).

While the method of forming patterns using a negative tone developer involves forming patterns by selectively dissolving and removing unexposed areas using a negative tone developer, the method of forming patterns using a positive tone developer involves forming patterns by selectively dissolving and removing exposed areas using a positive tone developer.

When compared to the method of forming patterns using a positive tone developer, the method of forming patterns using a negative tone developer facilitates the formation of patterns when realizing the same pattern by implementing reverse patterns in contact hole patterns or trench patterns, which are difficult to be formed due to insufficient exposure, and can form photoresist patterns more effectively by using organic solvents as developers for removing unexposed parts.

In the meantime, photolithography using photoresist compositions is typically composed of the following processes: applying a photoresist on a wafer for coating, evaporating a solvent by heating the coated photoresist for soft baking, producing an image by a light source passing through a photomask, forming a pattern by a difference in solubility of exposed and unexposed parts using a developer, and etching the wafer, thus completing a circuit.

Such a photoresist composition is made of a photosensitizer (photoacid generator) for generating acid through excimer laser irradiation, a base resin, and other additives. Polystyrene polymers with a structure in which a hydroxyl group is present in a phenolic structure are used basically as the base resin. In addition, any photosensitizer capable of generating acid (H⁺) at a specific wavelength is available. In most cases, photosensitizers based on sulfonium salt, sulfonyldiazo, benzosulfonyl, iodine, chlorine, carboxylic acid, and the like may be primarily used.

In addition, light sources primarily used for such processes as described above have a wavelength in the range of 365 nm to 193 nm, including an i-line, a krypton fluoride (KrF) excimer laser, and an argon fluoride (ArF) excimer laser. It is known that those having shorter wavelengths enable the formation of much finer patterns.

Among these, research and development of KrF laser (248 nm) photoresists, aiming for seeking optical micromachining, have continued despite the ArF laser (193 nm) system developed thereafter. This may be due to the following reasons: the development of next-generation ArF photoresists is not yet satisfactory, and the cost savings of using KrF or i-line photoresists for mass production of semiconductors are significant. In response to developments of such technologies, the performance of KrF or i-line photoresists also must be improved. For a representative example, a decrease in photoresist thickness continues to be required with high integration, so developments of photoresists with further enhanced dry etch resistance are in desperate need. Other required characteristics include high resolution, wide depth of focus (DOF) margin, defect-free thin film formation, adhesion to substrates, high contrast, fast sensitivity, chemical stability, and the like.

As described above, Korean Patent No. 10-0047038 "Chemically Amplified Positive Photoresist Composition", Korean Patent No. 10-1363842 "Chemically Amplified Positive Photoresist Composition and Method of Forming Resist Pattern Using Same", Korean Patent No. 10-1204915 "Photoresist Polymer, Photoresist Composition Including Same, and Method of Forming Photoresist Pattern Using Same", Korean Patent No. 10-0273108 "Copolymer for Preparing Photoresist and Chemically Amplified Positive Photoresist Composition Containing Same", Korean Patent No. 10-1655947 "Negative Photoresist Composition for KrF Laser Having High Resolution and High Aspect Ratio", Korean Patent No. 10-1977886 "Chemically Amplified Positive Photoresist Composition for Improving Pattern Profile", and the like are disclosed as patents in the art regarding KrF or i-line photoresist technology.

As described in the above patents, KrF or i-line photoresists primarily use polyhydroxystyrene and polystyrene polymers with good transmittance in a wavelength range of 248 nm to 365 nm as base polymers to improve resolution and sensitivity.

Such positive photoresists based on polyhydroxystyrene and polystyrene polymers have difficulties because the range thereof usable in processes based on light sources having wavelengths in the range of 248 nm to 365 nm is challenging due to slope pattern profiles, footing, or the like. Furthermore, disadvantages that the resolution realizable decreases as photoresist thickness increases, and depending on the type of underlying layer, problems such as lack of adhesion cause problems during processes, such as pattern collapse, are becoming critical issues.

### Disclosure

### Technical Problem

The present disclosure aims to provide a photoresist composition for a KrF or i-line light source, the photoresist composition having an improved pattern profile compared to conventional KrF or i-line positive photoresists by adding an appropriate amount of a polyhydric alcohol additive effective in improving a pattern profile and enhancing adhesion between a pattern and an underlying layer, and being capable of improving the process margin by preventing pattern collapse from occurring.

In other words, the present disclosure aims to provide a photoresist composition for a KrF or i-line light source, the photoresist composition having an improved pattern profile by enabling a vertical profile to be obtainable, and preventing pattern collapse from occurring by enabling stable adhesion between a pattern and an underlying layer to be obtainable.

### Technical Solution

To achieve the above-described objectives, the present disclosure provides a positive photoresist composition for a KrF or i-line light source, the photoresist composition including a polyhydric alcohol additive for enhancing adhesion between a pattern for a chemically amplified resist and an underlying layer, wherein the polyhydric alcohol additive is represented by Chemical Formulas 1 to 8 below and has a molecular weight in the range of 100 to 200.

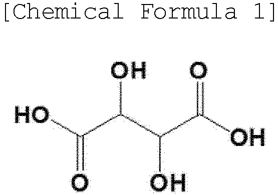

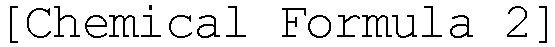

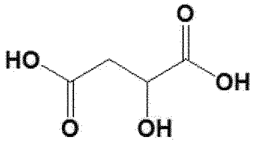

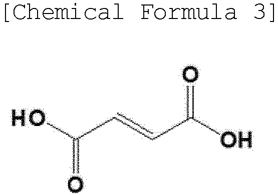

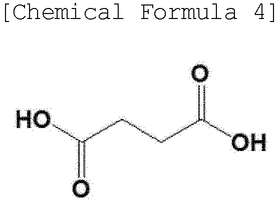

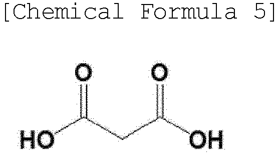

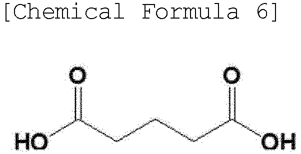

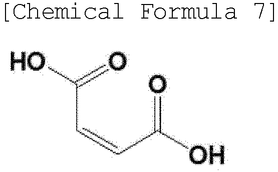

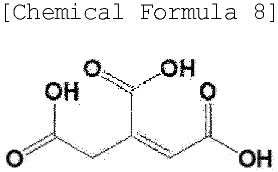

In one preferred embodiment of the present disclosure, the polyhydric alcohol additive, represented by the above chemical formulas, for enhancing the adhesion between the pattern for the resist and the underlying layer and similar structures are obtainable commercially from multiple suppliers in Korea domestically and abroad.

In one preferred embodiment of the present disclosure, the polyhydric alcohol additive, represented by the above chemical formulas, for enhancing the adhesion between the pattern for the resist and the underlying layer is characterized by having a molecular weight in the range of 100 to 200.

In one preferred embodiment of the present disclosure, the polyhydric alcohol additive for enhancing the adhesion between the pattern for the resist and the underlying layer is characterized by including 5 to 60 wt% of a polymer resin, 1 to 5 wt% of the polyhydric alcohol additive, represented by Chemical Formulas 1 to 8, for enhancing the adhesion between the pattern and the underlying layer, 0.05 to 10 wt% of a photoacid generator, 0.01 to 5 wt% of an acid diffusion inhibitor, and the remainder being a solvent, with respect to the total weight of the composition.

In one preferred embodiment of the present disclosure, any photoresist resin commonly used is available as the polymer resin, and the polymer resin is characterized by being one or more selected from the group consisting of hydroxyl group-containing phenolic polymer resins of Chemical Formulas 9 to 13 below.

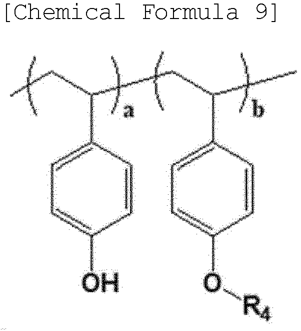

(In the structure of Chemical Formula 9, R4 is one structure selected from structures of Chemical Formulas a to p below.)

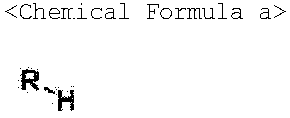

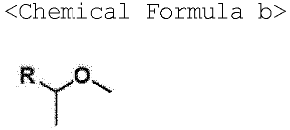

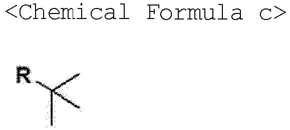

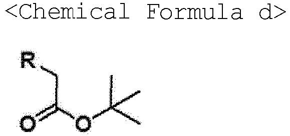

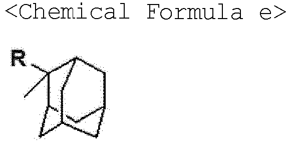

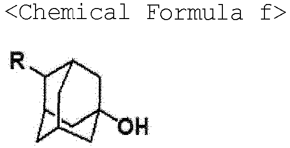

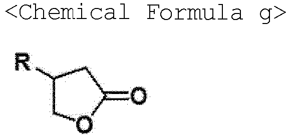

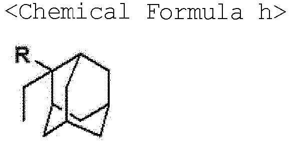

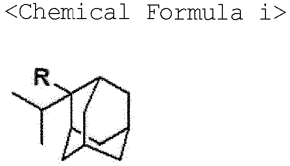

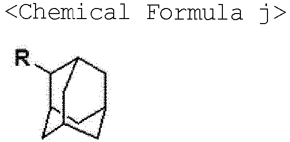

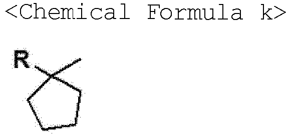

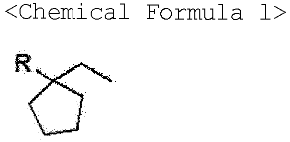

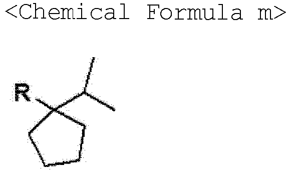

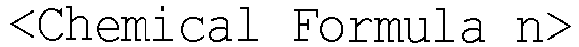

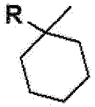

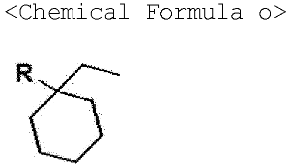

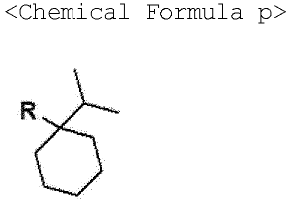

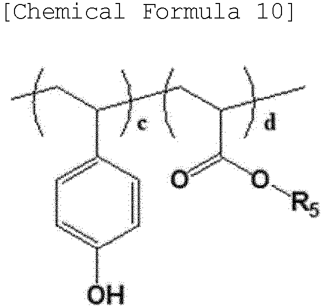

(In the structure of Chemical Formula 10, R5 is one structure selected from the structures of Chemical Formulas a to p.)

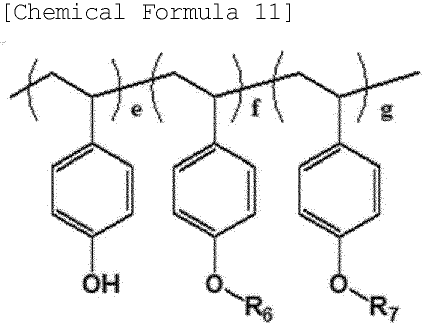

(In the structure of Chemical Formula 11, R6 and R7 are each independently one structure selected from the structures of Chemical Formulas a to p.)

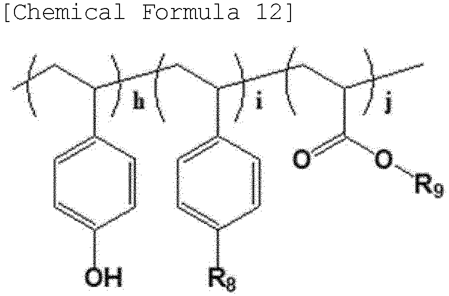

(In the structure of Chemical Formula 12, R8 and R9 are each independently one structure selected from the structures of Chemical Formulas a to p.)

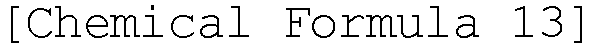

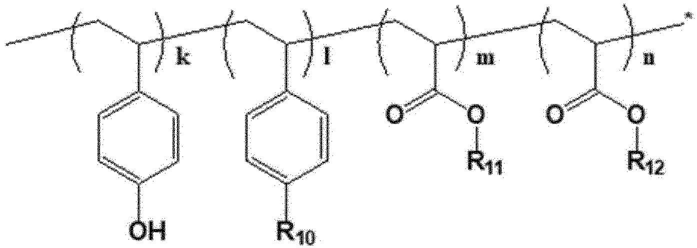

(In the structure of Chemical Formula 13, R10, R11, and R12 are each independently one structure selected from the structures of Chemical Formulas a to p.)

In one preferred embodiment of the present disclosure, the phenolic polymer resin is characterized by being one or more selected from the group consisting of the hydroxyl group-containing phenolic polymer resins of Chemical Formulas 9 to 13 below.

In one preferred embodiment of the present disclosure, the photoacid generator is characterized by including one or more selected from the group consisting of triphenylsulfoniumtriflate, triphenylsulfoniumantimonate, diphenyliodoniumtriflate, diphenyliodoniumantimonate, methoxydiphenyliodoniumtriflate, di-t-butyldiphenyliodoniumtriflate, norbornenedicarboxyimidetriflate, triphenylsulfoniumnonaflate, diphenyliodoniumnonaflate, methoxydiphenyliodoniumnonaflate, di-t-butyldiphenyliodoniumnonaflate, N-hydroxysuccinimidenonaflate, norbornenedicarboxyimidenonaflate, triphenylsulfoniumperfluorooctanesulfonate, diphenyliodoniumperfluorooctanesulfonate, methoxyphenyliodoniumperfluorooctanesulfonate, di-t-butyldiphenyliodoniumperfluorooctanesulfonate, N-hydroxysuccinimideperfluorooctanesulfonate, and norbornenedicarboxyimideperfluorooctanesulfonate.

In one preferred embodiment of the present disclosure, the acid diffusion inhibitor is characterized by including one or more selected from the group consisting of dimethylamine, diethylamine, trimethylamine, triethylamine, tributylamine, dimethanolamine, diethanolamine, trimethanolamine, triethanolamine, and tributanolamine.

### Advantageous Effects

The present disclosure can provide a photoresist composition for a KrF or i-line light source, the photoresist composition having an improved pattern profile compared to conventional KrF or i-line positive photoresists by adding an appropriate amount of a polyhydric alcohol additive effective in improving a pattern profile and enhancing adhesion between a pattern and an underlying layer, and being capable of improving the process margin by preventing pattern collapse from occurring.

In other words, the present disclosure can provide a photoresist composition for a KrF or i-line light source, the photoresist composition having an improved pattern profile by enabling a vertical profile to be obtainable, and preventing pattern collapse from occurring by enabling stable adhesion between a pattern and an underlying layer to be obtainable.

### Best Mode

Unless defined otherwise, all terms including technical and scientific terms used herein have the same meaning as those commonly understood by those skilled in the art to which the present disclosure pertains. In general, the nomenclature used herein is well-known and commonly used in the art.

Throughout this specification, it will be further understood that when one part is referred to as "comprising" or "including" one constituent element, this means that another constituent element may be further included but does not preclude the presence thereof unless the context clearly indicates otherwise.

In the present disclosure, the term "polyhydric alcohol additive for enhancing adhesion between a pattern and an underlying layer" provided refers to an additive capable of improving the adhesion through a reaction with the underlying layer in a thermal decomposition process during a post-exposure bake (PEB) or hard bake (HB) process to be conducted after a process of being exposed to a light source having a wavelength in the range of 248 nm to 365 nm.

In the present disclosure, the term "photoresist" refers to a mixture of a polymer and a photosensitizer, whose solubility in a specific solvent changes when exposed to light having a specific wavelength due to changes in the chemical properties thereof caused by light, meaning that, due to the difference in the dissolution rates of the exposed and unexposed parts in the solvent, the part that has not been completely dissolved remains when a predetermined period of dissolution time elapses, thus forming a pattern.

In the present disclosure, the term "photolithography" refers to a process in which when placing a mask, on which a semiconductor design is imprinted, between a light source and a coated photoresist film applied on a silicon wafer and turning on the light source, a circuit imprinted on the mask is transferred to a photoresist, using the properties of the photoresist as described above.

In the present disclosure, the term "KrF" refers to a light source having a wavelength of 248 nm, and the term "i-line" refers to a light source having a wavelength of 365 nm.

One embodiment of the present disclosure provides a chemically amplified positive photoresist composition for improving a pattern profile and enhancing adhesion, which is characterized by including a polyhydric alcohol additive for enhancing adhesion between a pattern and an underlying layer, wherein the polyhydric alcohol additive is represented by Chemical Formula 1 below.

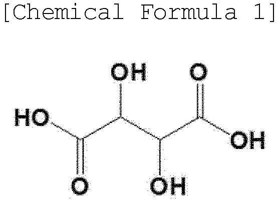

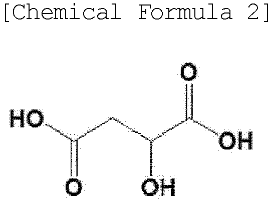

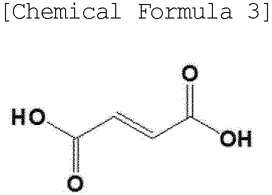

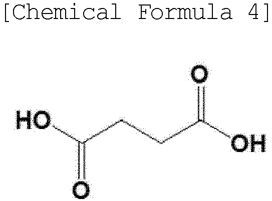

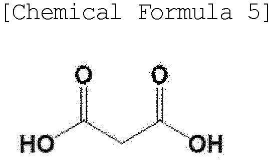

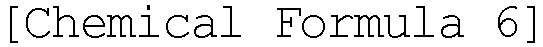

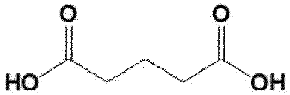

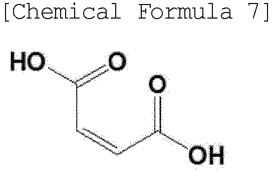

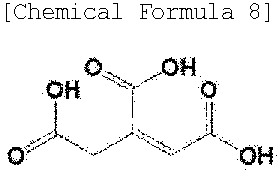

The positive photoresist composition for improving the pattern profile and enhancing adhesion, which includes the polyhydric alcohol additive for enhancing the adhesion between the pattern and the underlying layer, according to the present disclosure, may include 5 to 60 wt% of a polymer resin, 1 to 5 wt% of the polyhydric alcohol additive, represented by Chemical Formulas 1 to 8, for enhancing the adhesion between the pattern and the underlying layer, 0.05 to 10 wt% of a photoacid generator, 0.01 to 5 wt% of an acid diffusion inhibitor, and the remainder being a solvent, with respect to the total weight of the composition.

The polyhydric alcohol additive, represented by Chemical Formulas 1 to 8, for enhancing the adhesion between the pattern and the underlying layer is preferably included in an amount range of 1 to 5 wt%, with respect to the total weight of the composition. When the amount of the above compound used is less than 0.1 wt%, the amount of the polyhydric alcohol additive for enhancing the adhesion between the pattern and the underlying layer is significantly small. As a result, vertical profiles are unobtainable, and problems such as pattern collapse are released, meaning that there is no effect on adhesion improvement. When the amount of the above compound used exceeds 5 wt%, vertical profiles are obtainable, and pattern collapse is unproblematic, but this may cause a decrease in the process margin, involving reduced sensitivity and the like, which is undesirable.

Any photoresist resin commonly used is available as the polymer resin, and the polymer resin is characterized by being one or more selected from the group consisting of hydroxyl group-containing phenolic polymer resins of Chemical Formulas 9 to 13 below.

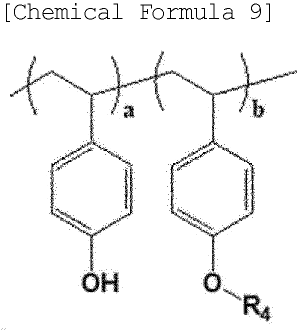

(In the structure of Chemical Formula 9, R4 is one structure selected from structures of Chemical Formulas a to p below.)

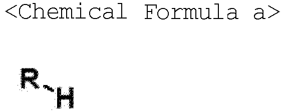

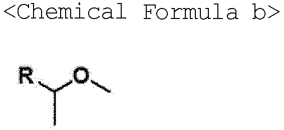

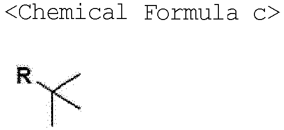

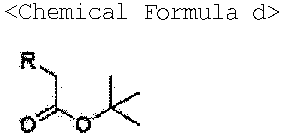

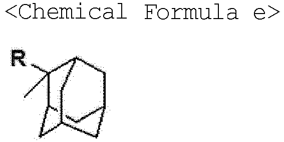

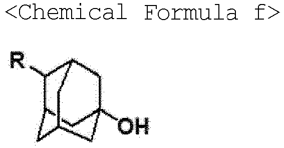

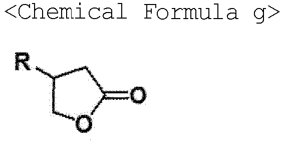

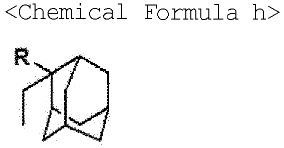

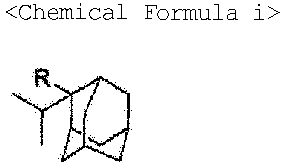

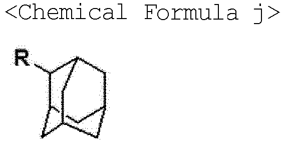

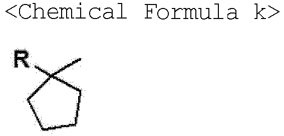

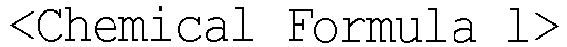

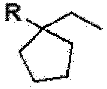

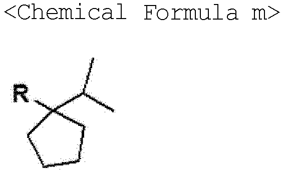

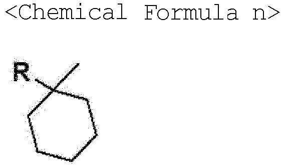

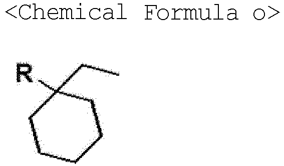

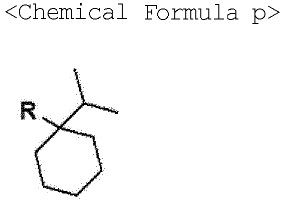

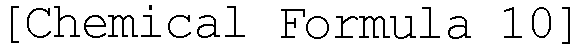

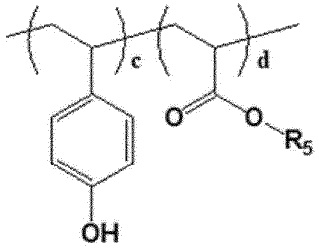

(In the structure of Chemical Formula 10, R5 is one structure selected from the structures of Chemical Formulas a to p.)

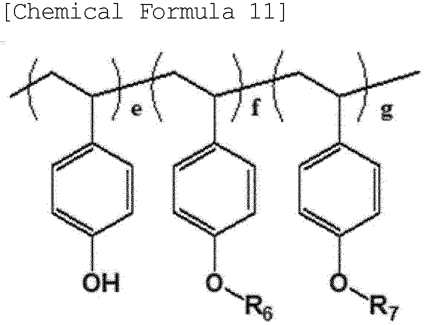

(In the structure of Chemical Formula 11, R6 and R7 are each independently one or more structures selected from the structures of Chemical Formulas a to p.)

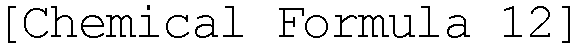

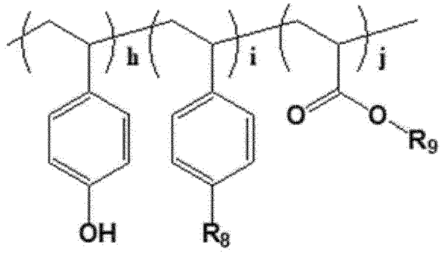

(In the structure of Chemical Formula 12, R8 and R9 are each independently one structure selected from the structures of Chemical Formulas a to p.)

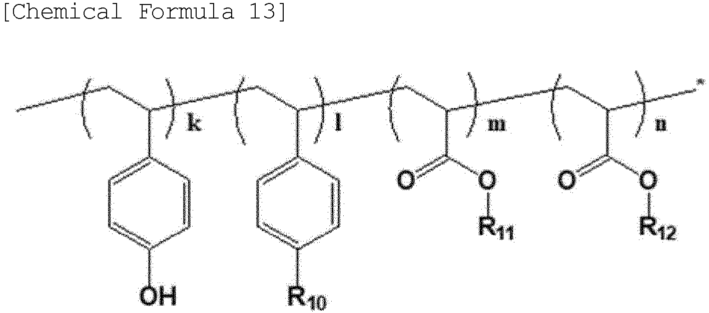

(In the structure of Chemical Formula 13, R10, R11, and R12 are each independently one structure selected from the structures of Chemical Formulas a to p.)

In one preferred embodiment of the present disclosure, the phenolic polymer resin is characterized by being one or more selected from the group consisting of the hydroxyl group-containing phenolic polymer resins of Chemical Formulas 9 to 13 below.

When it comes to the polymer resin, the polymer resin is preferably included in an amount range of 5 to 60 wt%, with respect to the total weight of the composition. When the amount of the polymer resin used is less than 5 wt%, there may be problems such as profile defects, scum, poor etch resistance, and the like. When the amount of the polymer resin used exceeds 60 wt%, there may be a problem that insufficient development causes patterning defects.

The photoacid generator may include one or more selected from the group consisting of triphenylsulfoniumtriflate, triphenylsulfoniumantimonate, diphenyliodoniumtriflate, diphenyliodoniumantimonate, methoxydiphenyliodoniumtriflate, di-t-butyldiphenyliodoniumtriflate, norbornenedicarboxyimidetriflate, triphenylsulfoniumnonaflate, diphenyliodoniumnonaflate, methoxydiphenyliodoniumnonaflate, di-t-butyldiphenyliodoniumnonaflate, N-hydroxysuccinimidenonaflate, norbornenedicarboxyimidenonaflate, triphenylsulfoniumperfluorooctanesulfonate, diphenyliodoniumperfluorooctanesulfonate, methoxyphenyliodoniumperfluorooctanesulfonate, di-t-butyldiphenyliodoniumperfluorooctanesulfonate, N-hydroxysuccinimideperfluorooctanesulfonate, and norbornenedicarboxyimideperfluorooctanesulfonate.

When it comes to the photoacid generator, the photoacid generator is preferably included in an amount range of 0.05 to 10 wt%, with respect to the total weight of the composition. When the amount of the photoacid generator used is less than 0.05 wt%, the slope surface of the pattern may become steep due to the insufficiently generated acid. When the amount of the photoacid generator used exceeds 10 wt%, the photoacid generator may absorb the light from an exposure source, resulting in reduced transmittance and thus causing problems of pattern defects such as poor definition.

The acid diffusion inhibitor may include one or more selected from the group consisting of dimethylamine, diethylamine, trimethylamine, triethylamine, tributylamine, dimethanolamine, diethanolamine, trimethanolamine, triethanolamine, and tributanolamine.

When it comes to the acid diffusion inhibitor, the acid diffusion inhibitor is preferably included in an amount range of 0.01 to 5 wt%, with respect to the total weight of the composition. When the amount of the acid diffusion inhibitor used is less than 0.01 wt%, the excessively generated acid may cause problems of pattern defects, leading to defects in the sidewall of patterns or those at the corners (line width roughness (LWR) and line edge roughness (LER)). When the amount of the acid diffusion inhibitor used exceeds 5 wt%, there may be cases where patterns are impossible to be formed, which is problematic.

In the meantime, the chemically amplified positive photoresist composition for improving the pattern profile and enhancing adhesion, which includes the polyhydric alcohol additives for enhancing the adhesion between the pattern and the underlying layer, of the present disclosure may have a thickness that is available from 2,000 Å to 200,000 Å depending on the types and amount of solvents to be used and may be dissolved in an amount range of 10 to 90 wt%, with respect to the weight of the solvent, for use.

Ethyleneglycolmonomethylether, ethyleneglycolmonoethylether, methylcellosolveacetate, ethylcellosolveacetate, diethyleneglycolmonomethylether, diethyleneglycolmonoethylether, propyleneglycolmonomethylether, propyleneglycolmethyletheracetate, propyleneglycolpropyletheracetate, diethyleneglycoldimethylether, ethyllactate, toluene, xylene, methylethylketone, cyclohexanone, 2-heptanone, 3-heptanone, 4-heptanone, and the like may be used as the solvent, either alone or in combination.

As stated, the chemically amplified positive photoresist composition for improving the pattern profile and enhancing adhesion, which includes the polyhydric alcohol additive of the present disclosure for enhancing the adhesion between the pattern and the underlying layer, provided from the present disclosure enables a vertical profile to be obtainable by exposure energy using the polyhydric alcohol additive, represented by Chemical Formulas 1 to 8, for enhancing the adhesion between the pattern and the underlying layer and is effective in adhesion enhancement, thus providing the process margin compared to conventional KrF or i-line photoresists (PRs).

### [Example]

Hereinafter, the present disclosure will be described in more detail through examples. These examples are only for illustrating the present disclosure, and it will be apparent to those skilled in the art that the scope of the present disclosure is not to be construed as being limited by these examples.

### Mode for Invention

### Example 1

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 3.5 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 106.0 g of propyleneglycolmonomethylether and 106.0 g of propyleneglycolmethyletheracetate as a solvent. The composition prepared above was applied on an aluminum (Al)-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 118 mJ/cm², and a positive slope pattern with a line/space resolution of 3.0 µm and a pattern slope angle of 84.3° was observed without pattern collapse.

### Example 2

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 5.0 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 107.5 g of propyleneglycolmonomethylether and 107.5 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 117 mJ/cm², and a positive slope pattern with a line/space resolution of 2.8 µm and a pattern slope angle of 84.9° was observed without pattern collapse.

### Example 3

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 7.5 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 110.0 g of propyleneglycolmonomethylether and 110.0 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 115 mJ/cm², and a positive slope pattern with a line/space resolution of 2.8 µm and a pattern slope angle of 85.4° was observed without pattern collapse.

### Example 4

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 10.0 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 112.5 g of propyleneglycolmonomethylether and 112.5 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 112 mJ/cm², and a positive slope pattern with a line/space resolution of 2.5 µm and a pattern slope angle of 88.8° was observed without pattern collapse.

### Example 5

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 12.5 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 115.0 g of propyleneglycolmonomethylether and 115.0 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 110 mJ/cm², and a positive slope pattern with a line/space resolution of 2.4 µm and a pattern slope angle of 89.2° was observed without pattern collapse.

### Example 6

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 13.0 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 115.5 g of propyleneglycolmonomethylether and 115.5 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 109 mJ/cm², and a fine negative slope pattern with a line/space resolution of 2.4 µm and a pattern slope angle of 91.9° was observed without pattern collapse.

### Example 7

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 14.0 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 116.5 g of propyleneglycolmonomethylether and 116.5 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 107 mJ/cm², and a fine negative slope pattern with a line/space resolution of 2.3 µm and a pattern slope angle of 92.2° was observed without pattern collapse.

### Example 8

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 15.5 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 118.0 g of propyleneglycolmonomethylether and 118.0 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 105 mJ/cm², and a fine negative slope pattern with a line/space resolution of 2.3 µm and a pattern slope angle of 94.8° was observed without pattern collapse.

### Example 9

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 17.5 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 119.0 g of propyleneglycolmonomethylether and 119.0 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 104 mJ/cm², and a fine negative slope pattern with a line/space resolution of 2.3 µm and a pattern slope angle of 95.1° was observed without pattern collapse.

### Comparative Example 1

The experiment was conducted in the same manner as in Example 1, except for not adding the polyhydric alcohol additive for enhancing the adhesion between the pattern and the underlying layer. As a result, the sensitivity was confirmed to be 125 mJ/cm², and a pattern with a line/space resolution of 3.5 µm was observed. However, it was confirmed that pattern collapse occurred.

### Comparative Example 2

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 2.5 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 105.0 g of propyleneglycolmonomethylether and 105.0 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 120 mJ/cm², and a pattern with a line/space resolution of 3.0 µm was observed. However, it was confirmed that pattern collapse occurred.

### Comparative Example 3

A positive photoresist composition for a KrF excimer laser was prepared using the following composition: 100 g of a phenolic polymer resin (a structure of Chemical Formula 12 in which R8 is Chemical Formula a, R9 is Chemical Formula c, and the respective copolymerization molar ratios of h, i, and j are 7, 2, and 1) having a weight average molecular weight of 15,000 as a base resin, 20.0 g of a polyhydric alcohol additive (a structure of Chemical Formula 1) for enhancing adhesion between a pattern and an underlying layer, the polyhydric alcohol additive having a weight average molecular weight of 150, 4 g of triphenylsulfonium nonaflate as a photoacid generator, and 0.6 g of triethanolamine as an acid diffusion inhibitor, with the use of a mixed solution of 119.5 g of propyleneglycolmonomethylether and 119.5 g of propyleneglycolmethyletheracetate as a solvent. The composition prepared above was applied on an Al-coated silicon wafer for coating using a spin coater, followed by soft baking at a temperature of 100°C for 120 seconds to confirm a target thickness of 5 um. Once an exposure process by a light source having a wavelength of 248 nm was completed, a baking process (PEB) was conducted at a temperature of 120°C for 90 seconds, followed by a development process with 2.38% tetramethylammoniumhydroxide to form a pattern. As a result, the sensitivity was confirmed to be 101 mJ/cm², and a fine negative slope pattern with a pattern slope angle of 96.6° was observed at a line/space resolution of 2.2 µm without pattern collapse.

### Property measurement

The properties of the chemically amplified positive photoresist compositions for improving the pattern profile and enhancing adhesion, prepared as in Examples 1 to 5 and Comparative Example 1 above, were measured.

Resolution and adhesion were measured using a critical-dimension scanning electron microscope (CD-SEM) capable of observing the line width (CD) of the patterns and confirmed by observing the line/space (L/S) minimum line width (resolution). In addition, regarding the sensitivity, the energy at which the minimum line width (resolution) was observable was measured to determine sensitivity.

The results measured as above are shown in Table 1 below.

**[Table 1]**

| | Additive (wt%) | Sensitivity (mJ/cm²) | Resolution (µm) | Pattern Angle (°) | Whether pattern collapse occurs or not |
|---|---|---|---|---|---|
| Example 1 | 1.093 | 119 | 3.0 | 84.3 | Normal profile formation |
| Example 2 | 1.540 | 117 | 2.8 | 84.9 | Normal profile formation |
| Example 3 | 2.258 | 115 | 2.8 | 85.4 | Normal profile formation |
| Example 4 | 2.945 | 112 | 2.5 | 88.8 | Normal profile formation |
| Example 5 | 3.601 | 110 | 2.4 | 89.2 | Normal profile formation |
| Example 6 | 3.729 | 109 | 2.4 | 91.9 | Normal profile formation |
| Example 7 | 3.982 | 108 | 2.3 | 92.2 | Normal profile formation |
| Example 8 | 4.353 | 105 | 2.3 | 94.8 | Normal profile formation |
| Example 9 | 4.860 | 104 | 2.3 | 95.1 | Normal profile formation |
| Comparative Example 1 | 0.000 | 125 | 3.5 | - | Collapse occurs |
| Comparative Example 2 | 0.788 | 120 | 3.0 | - | Collapse occurs |
| Comparative Example 3 | 5.501 | 101 | 2.2 | 96.6 | Normal profile formation |

As confirmable in Table 1, the evaluation results with the addition of the polyhydric alcohol additive for enhancing the adhesion between the pattern and the underlying layer confirmed that Examples 1 to 9 exhibited improved sensitivity compared to Comparative Examples 1 and 2, and the resolution, indicating the minimum line width, was also confirmed to be improved. In addition, the pattern slope was also confirmed to be more vertical.

When involving 1 to 5 wt% of the polyhydric alcohol additive for enhancing the adhesion between the pattern and the underlying layer in the examples, the results showed that the sensitivity, the resolution, and the pattern angle were confirmed to be excellent overall. Especially when involving 2.9 to 4.0 wt% of the polyhydric alcohol additive, as in the case of Examples 4 to 7, the results showed that the sensitivity, the resolution, and the pattern angle were confirmed to be excellent overall. The results confirmed using the CD-SEM showed that Comparative Examples 2 and 3 exhibited improved resolution, indicating the minimum line width, and sensitivity compared to Comparative Example 1, but pattern collapse was observed in some areas.

Any simple modifications or changes to the present disclosure may be readily implemented by those skilled in the art and are to be regarded as falling within the scope of the present disclosure.

## Claims

1. A chemically amplified positive photoresist composition for improving a pattern profile and enhancing adhesion, the photoresist composition being exposable by a light source having a wavelength of 248 nm and comprising 1 to 5 wt% of a polyhydric alcohol additive represented by Chemical Formulas 1 to 8 below to implement a vertical profile without pattern collapse.

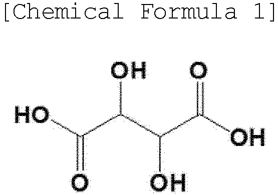

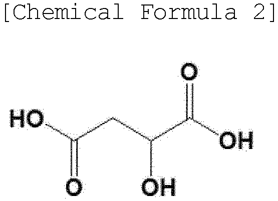

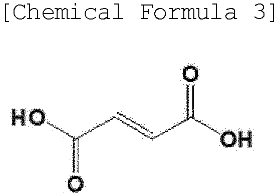

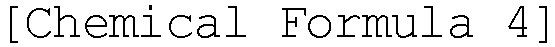

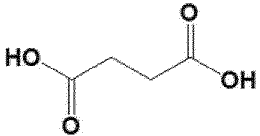

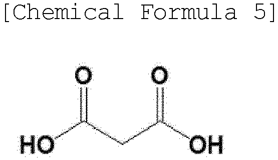

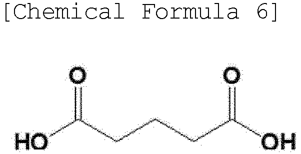

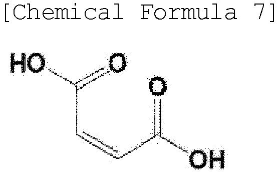

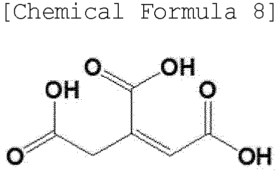

2. The photoresist composition of claim 1, wherein the photoresist composition comprises 5 to 60 wt% of a polymer resin, 1 to 5 wt% of the polyhydric alcohol additive, 0.05 to 10 wt% of a photoacid generator, 0.01 to 5 wt% of an acid diffusion inhibitor, and the remainder being a solvent, with respect to the total weight of the composition.

3. The photoresist composition of claim 2, wherein the polymer resin is one or more selected from the group consisting of hydroxyl group-containing phenolic polymer resins of Chemical Formulas 9 to 13 below, 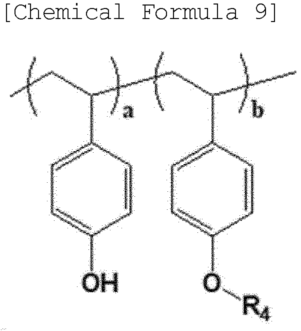
(where in the structure of Chemical Formula 9, R4 is one structure selected from structures of Chemical Formulas a to p below) 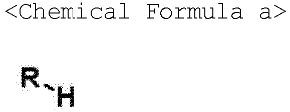 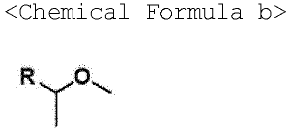 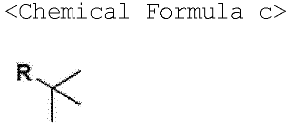 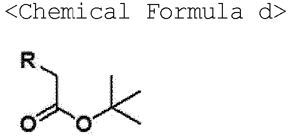 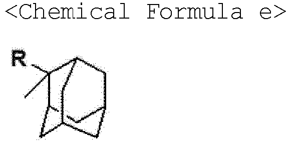 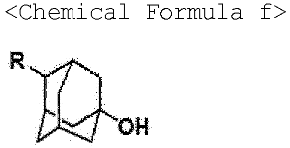 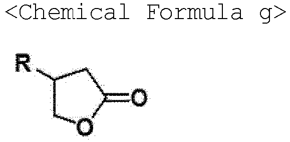 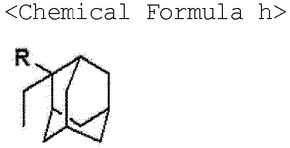 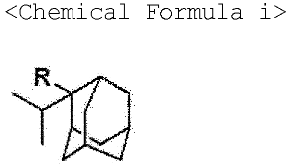 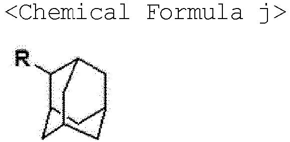 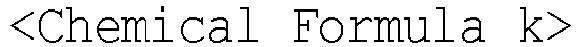 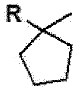 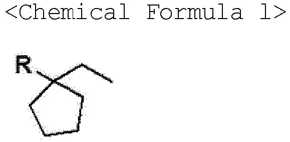 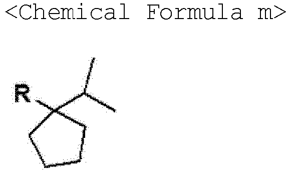 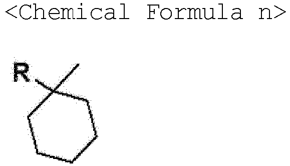 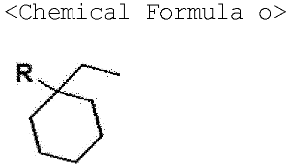 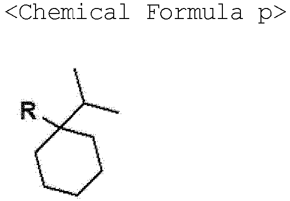 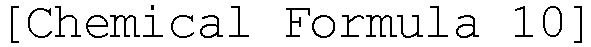 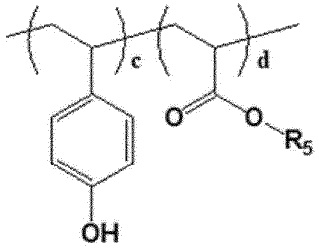
(where in the structure of Chemical Formula 10, R5 is one structure selected from the structures of Chemical Formulas a to p) 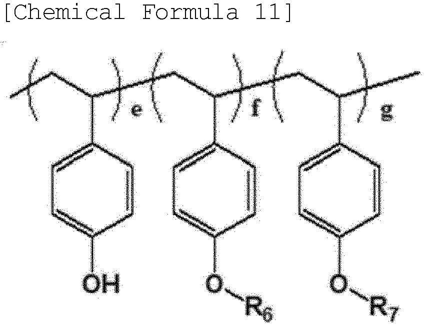
(where in the structure of Chemical Formula 11, R6 and R7 are each independently one structure selected from the structures of Chemical Formulas a to p) 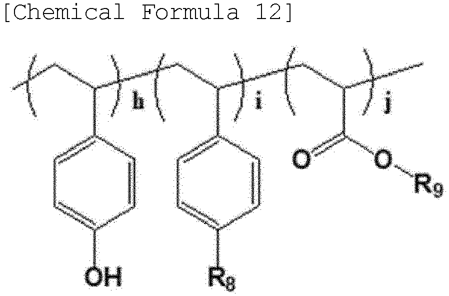
(where in the structure of Chemical Formula 12, R8 and R9 are each independently one structure selected from the structures of Chemical Formulas a to p) 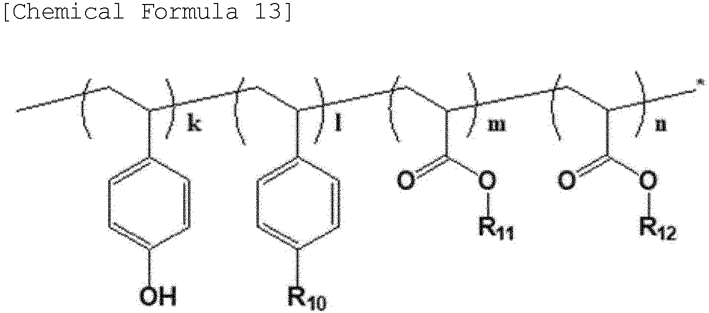
(where in the structure of Chemical Formula 13, R10, R11, and R12 are each independently one structure selected from the structures of Chemical Formulas a to p).

4. The photoresist composition of claim 2, wherein the photoacid generator comprises one or more selected from the group consisting of triphenylsulfoniumtriflate, triphenylsulfoniumantimonate, diphenyliodoniumtriflate, diphenyliodoniumantimonate, methoxydiphenyliodoniumtriflate, di-t-butyldiphenyliodoniumtriflate, 2,6-dinitrobenzylsulfonate, pyrogalloltrisalkylsulfonate, norbornenedicarboxyimidetriflate, triphenylsulfoniumnonaflate, diphenyliodoniumnonaflate, methoxydiphenyliodoniumnonaflate, di-t-butyldiphenyliodoniumnonaflate, N-hydroxysuccinimidenonaflate, norbornenedicarboxyimidenonaflate, triphenylsulfoniumperfluorooctanesulfonate, diphenyliodoniumperfluorooctanesulfonate, methoxydiphenyliodoniumperfluorooctanesulfonate, di-t-butyldiphenyliodoniumperfluorooctanesulfonate, N-hydroxysuccinimideperfluorooctanesulfonate, and norbornenedicarboxyimideperfluorooctanesulfonate.

5. The photoresist composition of claim 2, wherein the acid diffusion inhibitor comprises one or more selected from the group consisting of dimethylamine, diethylamine, trimethylamine, triethylamine, tributylamine, dimethanolamine, diethanolamine, trimethanolamine, triethanolamine, and tributanolamine.
